(19) **Europäisches Patentamt / European Patent Office / Office européen des brevets**

(11) **EP 2 765 656 B1**

(12) **EUROPEAN PATENT SPECIFICATION**

(45) Date of publication and mention of the grant of the patent:
**14.11.2018 Bulletin 2018/46**

(51) Int Cl.:
*H01R 13/6466* (2011.01)  *H01R 24/64* (2011.01)
*H01R 13/6463* (2011.01)  *H01R 24/28* (2011.01)

(21) Application number: **14151014.9**

(22) Date of filing: **13.01.2014**

(54) **Patch cord**

Steckschnur

Cordon de connexion

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **23.01.2013  US 201361755581 P**
**08.02.2013  US 201313762433**
**14.03.2013  US 201313802882**

(43) Date of publication of application:
**13.08.2014  Bulletin 2014/33**

(73) Proprietor: **CommScope, Inc. of North Carolina**
**Hickory, NC 28602 (US)**

(72) Inventors:
• **Schumacher, Richard A.**
  **Dallas, TX 75248-4940 (US)**

• **Hashim, Amid I.**
  **Plano, TX 75093 (US)**
• **Fitzpatrick, Brian J.**
  **McKinney, TX 75070 (US)**
• **Moffitt, Bryan S.**
  **Red Bank, NJ 07701 (US)**
• **Larsen, Wayne D.**
  **Wylie, TX 75098 (US)**
• **Michaelis, Scott L.**
  **PLANO, TX 75075 (US)**

(74) Representative: **Yeadon IP Limited**
**Leeds Innovation Centre**
**103 Clarendon Road**
**Leeds LS2 9DF (GB)**

(56) References cited:
**WO-A1-2006/081423      US-A1- 2010 317 230**
**US-A1- 2012 100 744**

EP 2 765 656 B1

**Description**

FIELD OF THE INVENTION

The present invention relates generally to a patch cord comprising a communications cable and a plug.

BACKGROUND

US-2012/100744 discloses a patch cord comprising a communication cable and a plug having four contacts. US2010/317230 discloses a patch cord according to the preamble of claim 1.

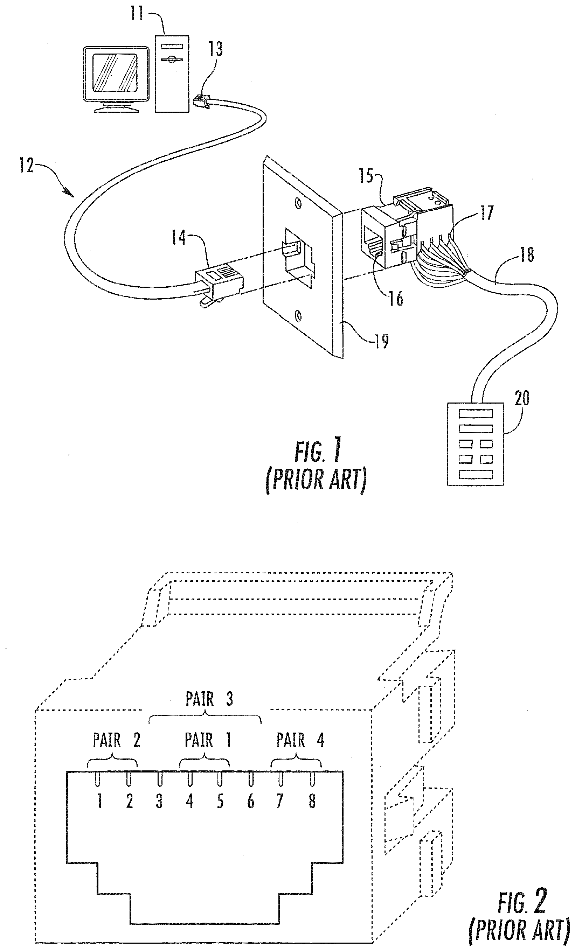

Many hardwired communications systems use plug and jack connectors to connect a communications cable to another communications cable or to computer equipment. By way of example, high speed communications systems routinely use such plug and jack connectors to connect computers, printers and other devices to local area networks and/or to external networks such as the Internet. **FIG. 1** depicts a highly simplified example of such a hardwired high speed communications system that illustrates how plug and jack connectors may be used to interconnect a computer **11** to, for example, a network server **20**.

As shown in **FIG. 1**, the computer **11** is connected by a cable **12** to a communications jack **15** that is mounted in a wall plate **19**. The cable **12** is a patch cord that includes a communications plug **13, 14** at each end thereof. Typically, the cable **12** includes eight insulated conductors. As shown in **FIG. 1**, plug **14** is inserted into an opening or "plug aperture" **16** in the front side of the communications jack **15** so that the contacts or "plug blades" of communications plug **14** mate with respective contacts of the communications jack **15**. If the cable **12** includes eight conductors, the communications plug **14** and the communications jack **15** will typically each have eight contacts. The communications jack **15** includes a wire connection assembly **17** at the back end thereof that receives a plurality of conductors (e.g., eight) from a second cable **18** that are individually pressed into slots in the wire connection assembly **17** to establish mechanical and electrical connections between each conductor of the second cable **18** and a respective one of a plurality of conductive paths through the communications jack **15**. The other end of the second cable **18** is connected to a network server **20** which may be located, for example, in a telecommunications closet of a commercial office building. Communications plug **13** similarly is inserted into the plug aperture of a second communications jack (not pictured in **FIG. 1**) that is provided in the back of the computer **11**. Thus, the patch cord **12**, the cable **18** and the communications jack **15** provide a plurality of electrical paths between the computer **11** and the network server **20**. These electrical paths may be used to communicate electrical information signals between the computer **11** and the network server **20**.

When a signal is transmitted over a conductor (e.g., an insulated copper wire) in a communications cable, electrical noise from external sources may be picked up by the conductor, degrading the quality of the signal. In order to counteract such noise sources, the information signals in the above-described communications systems are typically transmitted between devices over a pair of conductors (hereinafter a "differential pair" or simply a "pair") rather than over a single conductor. The two conductors of each differential pair are twisted tightly together in the communications cables and patch cords so that the eight conductors are arranged as four twisted differential pairs of conductors. The signals transmitted on each conductor of a differential pair have equal magnitudes, but opposite phases, and the information signal is embedded as the voltage difference between the signals carried on the two conductors of the pair. When the signal is transmitted over a twisted differential pair of conductors, each conductor in the differential pair often picks up approximately the same amount of noise from these external sources. Because the information signal is extracted by taking the difference of the signals carried on the two conductors of the differential pair, the subtraction process may mostly cancel out the noise signal, and hence the information signal is typically not disturbed.

Referring again to **FIG. 1**, it can be seen that a series of plugs, jacks and cable segments connect the computer **11** to the server **20**. Each plug, jack and cable segment includes four differential pairs, and thus a total of four differential transmission lines are provided between the computer **11** and the server **20** that may be used to carry two way communications therebetween (e.g., two of the differential pairs may be used to carry signals from the computer **11** to the server **20**, while the other two may be used to carry signals from the server **20** to the computer **11**). The cascaded plugs, jacks and cabling segments shown in **FIG. 1** that provide connectivity between two end devices (e.g., computer **11** and server **20**) is referred to herein as a "channel." Thus, in most high speed communications systems, a "channel" includes four differential pairs. Unfortunately, the proximities of the conductors and contacting structures within each plug-jack connection (e.g., where plug **14** mates with jack **15**) can produce capacitive and/or inductive couplings. These capacitive and inductive couplings in the connectors (and similar couplings that may arise in the cabling) give rise to another type of noise that is known as "crosstalk."

In particular, "crosstalk" refers to unwanted signal energy that is capacitively and/or inductively coupled onto the conductors of a first "victim" differential pair from a signal that is transmitted over a second "disturbing" differential pair. The induced crosstalk may include both near-end crosstalk (NEXT), which is the crosstalk measured at an input location corresponding to a source at the same location (i.e., crosstalk whose induced voltage signal travels in an opposite direction to that of an originating, disturbing signal in a different path), and far-end crosstalk (FEXT), which is the crosstalk measured at the output location corresponding to a source at the input location (i.e., crosstalk whose signal travels in the same direction as the disturbing signal in the different path). Both types of crosstalk comprise an undesirable noise signal that interferes with the information signal that is transmitted over the victim differential pair.

While methods are available that can significantly reduce the effects of crosstalk within communications cable segments, the communications connector configurations that were adopted years ago - and which still are in effect in order to maintain backwards compatibility - generally did not arrange the contact structures so as to minimize crosstalk between the differential pairs in the connector hardware. For example, pursuant to the ANSI/TIA-568-C.2 standard approved August 11, 2009 by the Telecommunications Industry Association, in the connection region where the contacts of a modular plug mate with the contacts of the modular jack (referred to herein as the "plug-jack mating region"), the eight contacts **1-8** of the jack must be aligned in a row, with the eight contacts **1-8** arranged as four differential pairs specified as depicted in **FIG. 2**. As known to those of skill in the art, under the TIA/EIA 568 type B configuration, contacts **4** and **5** in **FIG. 2** comprise pair 1, contacts **1** and **2** comprise pair 2, contacts **3** and **6** comprise pair 3, and contacts **7** and **8** comprise pair 4. As is apparent from **FIG. 2**, this arrangement of the eight contacts **1-8** will result in unequal coupling between the differential pairs, and hence both NEXT and FEXT is introduced in each connector in industry standardized communications systems.

As hardwired communications systems have moved to higher frequencies in order to support increased data rate communications, crosstalk in the plug and jack connectors has became a more significant problem. To address this problem, communications jacks now routinely include crosstalk compensation circuits that introduce compensating crosstalk that is used to cancel much of the "offending" crosstalk that is introduced in the plug-jack mating region as a result of the industry-standardized connector configurations. Typically, so-called "multi-stage" crosstalk compensation circuits are used. Such crosstalk circuits are described in U.S. Patent No. 5,997,358 to Adriaenssens et al., the entire content of which is hereby incorporated herein by reference as if set forth fully herein.

Another important parameter in communications connectors is the return loss that is experienced along each differential pair (i.e., differential transmission line) through the connector. The return loss of a transmission line is a measure of how well the transmission line is impedance matched with a terminating device or with loads that are inserted along the transmission line. In particular, the return loss is a measure of the signal power that is lost due to signal reflections that may occur at discontinuities (impedance mismatches) in the transmission line. Return loss is typically expressed as a ratio in decibels (dB) as follows:

$$RL(\mathrm{dB}) = 10\log_{10}\frac{P_\mathrm{i}}{P_\mathrm{r}}$$

where RL(dB) is the return loss in dB, Pi is the incident power and $P_\mathrm{r}$ is the reflected power. High return loss values indicate a good impedance match (i.e., little signal loss due to reflection), which results in lower insertion loss values, which is desirable.

SUMMARY

Pursuant to embodiments of the present invention which is defined by the appended claims, patch cords are provided that include a communications cable that includes at least first through fourth conductors and a plug that is attached to a first end of the cable. This plug includes a housing that receives the cable, a printed circuit board that is at least partly within the housing, and first through fourth plug contacts that each are at least partially within the housing. First through fourth conductive paths connect the respective first through fourth conductors to the respective first through fourth plug contacts. The first and second conductive paths are part of a first differential transmission line through the plug and the third and fourth conductive paths are part of a second differential transmission line through the plug. Each of the first through fourth plug contacts has a first segment that extends longitudinally above a first surface of the printed circuit board, and signal current injection points from the printed circuit board into the first segment of at least some of the first through fourth plug contacts are into middle portions of their respective first segments According to the invention, the respective signal current injection points from the printed circuit board into the first and third plug contacts are aligned in a first transverse row, and the respective signal current injection points from the printed circuit board into the second and fourth plug contacts are offset from the first row.

In some embodiments, the plug-jack mating point on the first plug contact is on a top side of the first plug contact, and the signal current injection point into the first plug contact is on a bottom side of the first plug contact substantially opposite this plug-jack mating point. Substantially the entirety of the first segment of the first plug contact may rest directly on the top surface of the printed circuit board. The first through fourth plug contacts may also each have a respective second segment that extends downwardly from an end of the respective first segments along a front edge of the printed circuit board. A minimum signal current-carrying path through the first plug contact may be less than twice a height of the first plug contact above a top surface of the printed circuit board. The respective signal current injection points into the second and fourth plug contacts may be aligned in a second transverse row that is offset from the first transverse row.

In some embodiments, the printed circuit board may include a plurality of conductive vias, and each of the first through fourth plug contacts may have a downwardly extending projection that is received within a respective one of the conductive vias. In such embodiments, the conductive vias that receive the downwardly extending projections of the first and third plug contacts may be aligned in a first row, and the conductive vias that receive the downwardly extending projections of the second and fourth plug contacts may be aligned in a second row that is offset from a first row.

In some embodiments, the first segments of the first through fourth plug contacts may be substantially identical and may be transversely aligned in a row, and substantially the entirety of the first segment of each of the first through fourth plug contacts may rest directly on the top surface of the printed circuit board. The signal current-carrying path through each of the first through fourth plug contacts may be offset in a longitudinal dimension of the plug from the signal current-carrying path of at least an adjacent one of the first through fourth plug contacts.

In some embodiments, the plug may be an RJ-45 plug that further includes fifth and sixth plug contacts that are part of a third differential transmission line through the plug and seventh and eighth plug contacts that are part of a fourth differential transmission line through the plug, wherein the first, third, fifth and seventh plug contacts are mounted in respective first through fourth conductive vias that are aligned in a first row and the second, fourth, sixth and eighth plug contacts are mounted in respective fifth through eighth conductive vias that are aligned in a second row that is offset from the first row. In some embodiments, the first through fourth plug contacts may extend no more than 90 mils (2.286mm) above a top surface of the printed circuit board. In other embodiments, the first through fourth plug contacts may extend no more than 60 mils (1.524mm) above a top surface of the printed circuit board. In still other embodiments, the first through fourth plug contacts may extend no more than 30 (0.762mm) mils above a top surface of the printed circuit board. In fact, in some embodiments, the first through fourth plug contacts may extend no more than 10 mils (0.254mm) above a top surface of the printed circuit board. These low profile plug contacts may generate substantially less offending crosstalk as compared to conventional plug blades.

In some embodiments, the plug further includes an offending crosstalk capacitor that injects offending crosstalk between the second conductive path and the third conductive path. This offending crosstalk capacitor may be a printed circuit board capacitor that injects offending crosstalk onto the second conductive path substantially at a first interface between the second plug contact and the printed circuit board, and onto the third conductive path substantially at a second interface between the third plug contact and the printed circuit board. In other embodiments, the offending crosstalk capacitor may be configured to inject offending crosstalk onto the second conductive path at a point in time that is after the point in time when a signal transmitted through the second plug contact to a contact of a mating jack reaches the contact of the mating jack. A fifth via that is part of the first conductive path is located in a portion of the printed circuit board that is underneath the first through fourth plug contacts. This fifth via is part of an offending crosstalk circuit. A sixth via that is part of the third conductive path is likewise located in the portion of the printed circuit board that is underneath the first through fourth plug contacts.

In some embodiments, the offending crosstalk circuit injects inductive crosstalk between the first conductive path and the fourth conductive path. A first trace of the printed circuit board that is part of the first conductive path may be positioned to inductively couple with a second trace on the printed circuit board that is part of the fourth conductive path to provide a second offending crosstalk circuit. The plug may include a second offending crosstalk circuit that includes the sixth via that injects inductive crosstalk between the second conductive path and the third conductive path. Each of the first through fourth plug contacts may have a first segment that extends longitudinally above a top surface of the printed circuit board, and the fifth via may be substantially transversely aligned with the sixth via. The first and third vias may be transversely aligned in a first row, and the second and fourth vias may be transversely aligned in a second row that is offset from a first row. The fifth via and the sixth via may be transversely aligned with the first and third vias.

BRIEF DESCRIPTION OF THE DRAWINGS

FIG. 1 is a simplified schematic diagram illustrating the use of conventional communications plugs and jacks to interconnect a computer with network equipment.

FIG. 2 is a schematic diagram illustrating the modular jack contact wiring assignments for a conventional 8-position communications jack (TIA 568B) as viewed from the front opening of the jack.

FIG. 3 is a perspective view of a patch cord according to certain embodiments of the present invention.

FIG. 4 is a top-rear perspective view of a plug that is included on the patch cord of FIG. 3.

FIG. 5 is a bottom-rear perspective view of the plug of FIG. 4.

FIG. 6 is a side view of the plug of FIG. 4.

FIGS. 7-10 are various perspective views of the plug contacts and a printed circuit board of the plug of FIGS. 4-6.

FIG. 11 is a schematic side cross-sectional view of the plug contacts and a front portion of the printed circuit board of the plug of FIGS. 4-6 shown mating with the jackwire contacts of a mating jack.

**FIG. 12** is a top, partial perspective view of a printed circuit board of a plug according to further embodiments of the present invention.

**FIG. 13** is a schematic side view of the front portion of a printed circuit board of a plug according to still further embodiments of the present invention.

**FIG. 14** is a schematic front view of plug contacts that may be included in plugs according to further embodiments of the present invention.

DETAILED DESCRIPTION

The present invention is directed to communications connectors such as RJ-45 plugs. As used herein, the terms "forward" and "front" and derivatives thereof refer to the direction defined by a vector extending from the center of the plug toward the portion of the plug that is first received within a plug aperture of a jack when the plug is mated with a jack. Conversely, the term "rearward" and derivatives thereof refer to the direction directly opposite the forward direction. The forward and rearward directions define the longitudinal dimension of the plug. The vectors extending from the center of the plug toward the respective sidewalls of the plug housing defines the transverse dimension of the plug. The transverse dimension is normal to the longitudinal dimension. The vectors extending from the center of the plug toward the respective top and bottom walls of the plug housing (where the top wall of the plug housing is the wall that includes slots that expose the plug blades) defines the vertical dimension of the plug. The vertical dimension of the plug is normal to both the longitudinal and transverse dimensions.

Pursuant to embodiments of the present invention, communications plugs, as well as patch cords that include such communications plugs, are provided that may exhibit excellent crosstalk, return loss and insertion loss performance. Some embodiments of these plugs may operate at frequencies supporting 40 gigabit communications.

In some embodiments, the communications plugs may include a printed circuit board and a plurality of low-profile plug contacts that are mounted on the top surface of the printed circuit board along a front edge thereof. The communications plug may comprise an RJ-45 plug that has eight plug contacts that are arranged as four differential pairs of plug contacts. Each of the plug contacts has a first segment that extends longitudinally above a top surface of the printed circuit board. The signal current injection point into the first segment of at least some of the plug contacts may be into middle portions of their respective first segments. Herein the "signal current injection point" into a plug contact refers to a point or region of the plug contact where electrical signals that are traversing the plug contact are transferred to a mating structure such as a mating jack contact, a printed circuit board, etc.

In some embodiments, the signal current injection points from the printed circuit board into the respective plug contacts may be aligned in two transverse rows. The signal current injection points into adjacent plug contacts may be staggered. For example, the plug may have first through eighth plug contacts that are aligned in numerical order in a row along a top surface of the printed circuit board in the transverse dimension of the plug, with the signal current injection points from the printed circuit board into plug contacts one, three, five and seven aligned in a first row and the signal current injection points from the printed circuit board into plug contacts two, four, six and eight aligned in a second row that is offset from the first row in the longitudinal dimension of the plug. This staggered arrangement may facilitate, among other things, reducing the amount of offending crosstalk between adjacent plug blades that is injected between differential pairs farther back in the plug (i.e., toward the wire connections in the plug) so that the vast bulk of the offending crosstalk may be injected close to the plug-jack mating point using offending crosstalk circuits. This may make it easier to effectively compensate for such offending crosstalk in a mating communications jack connector, as will be discussed in more detail below.

In some embodiments, the plug-jack mating point on each plug contact may be on a top side of the plug contact, and the signal current injection point into each plug contact may be on a bottom side of the plug contact substantially opposite the plug-jack mating point. This may provide for extremely short current paths through each plug contact, which may also facilitate providing improved crosstalk performance. Moreover, the low profile plug blades may extend, for example, less than 30 mils (0.762mm) above a top surface of the printed circuit board. In some embodiments, the minimum signal current-carrying path through each plug contact may be less than three times a height of the plug contact above the top surface of the printed circuit board. In other embodiments, the minimum signal current-carrying path through each plug contact may less than twice the height of the plug contact above the top surface of the printed circuit board, and may even be equal to the height of the plug contact above the top surface of the printed circuit board. Thus, the signal current carrying path through the plug contacts may be as low as, for example, less than 30 mils (0.762mm).

In some embodiments, each plug contact may include a downward projection that is received within a respective one of a plurality of conductive vias in the printed circuit board that are used to mount the plug contacts to the printed circuit board. These conductive vias may be staggered in at least two longitudinally offset transverse rows. In some embodiments, the signal current is injected into each plug contact via these conductive vias.

Pursuant to further embodiments of the present invention, RJ-45 communications plugs (and related patch cords) are provided that include eight low profile plug contacts that are mounted in eight respective conductive vias to extend along the top surface of a printed circuit board along a front edge thereof. At least a ninth conductive via is provided that is disposed between two of the eight conductive vias. The ninth conductive via is part of a first offending inductive crosstalk circuit. In some embodiments, a tenth conductive via is provided that is also disposed between two of the eight conductive vias that is part of a second offending inductive crosstalk circuit. The ninth and tenth conductive vias may provide a mechanism for injecting relatively high levels of offending inductive crosstalk between differential transmission lines of the plug very close to the plug-jack mating point.

Embodiments of the present invention will now be discussed in greater detail with reference to the drawings.

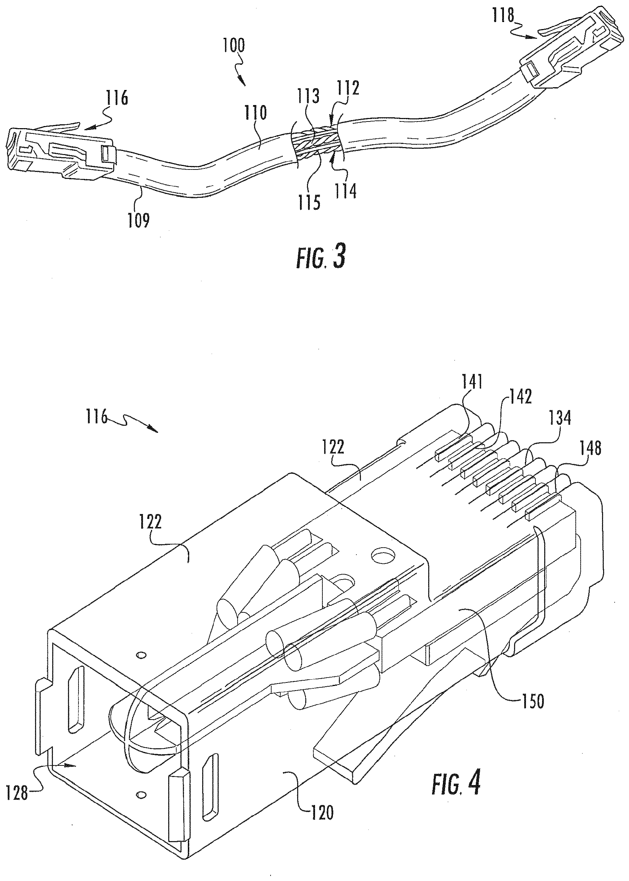

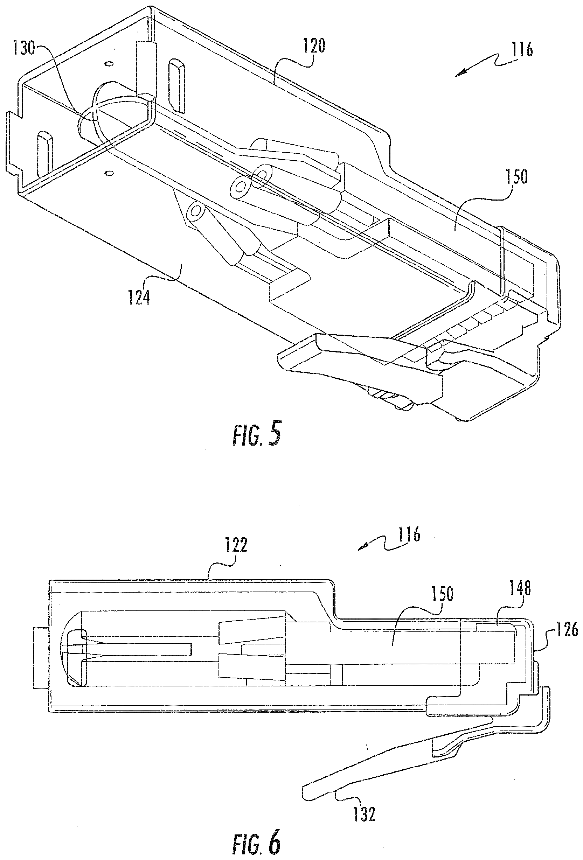

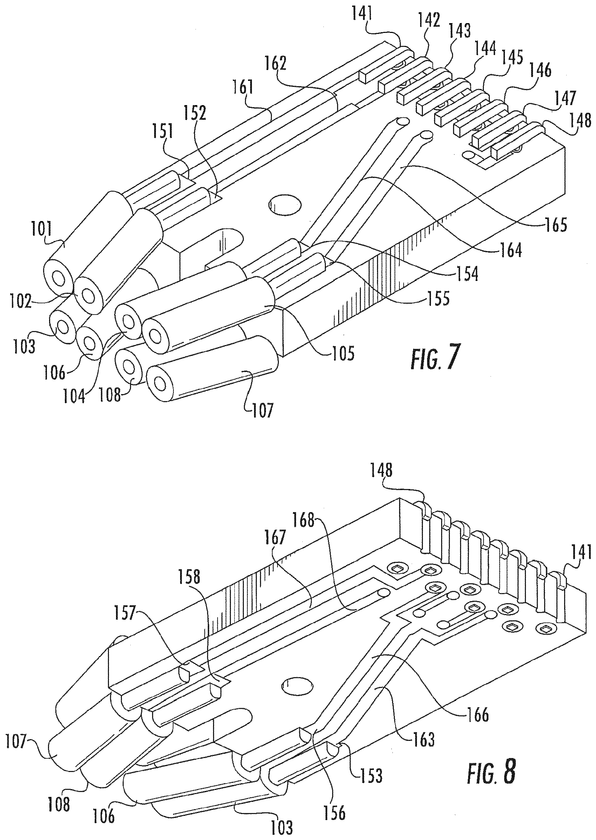

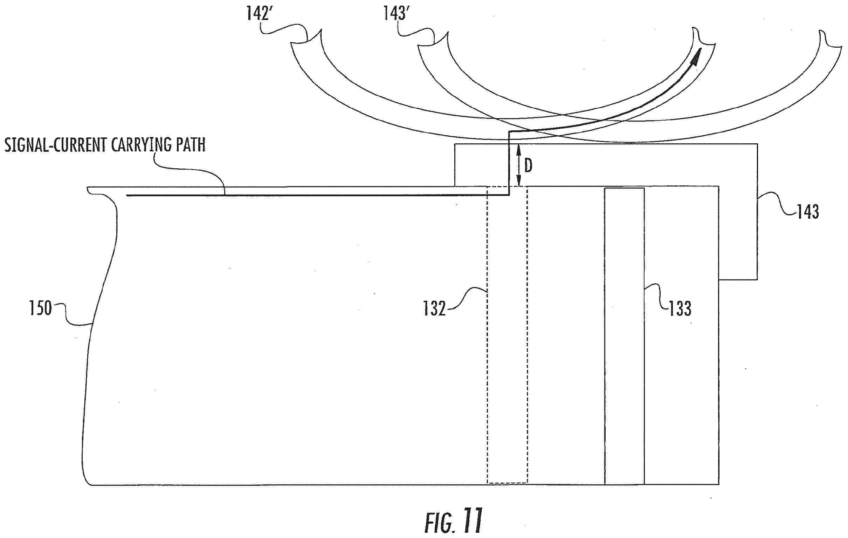

**FIGS. 3-11** illustrate a patch cord **100** and various components thereof according to certain embodiments of the present invention. In particular, **FIG. 3** is a perspective view of the patch cord **100**. **FIG. 4** is a top-rear perspective view of a plug **116** that is included on the patch cord **100** of **FIG. 3. FIG. 5** is a bottom-rear perspective view of the plug **116**. **FIG. 6** is a side view of the plug **116**. **FIGS. 7-10** are various perspective views of the plug contacts **141-148** and a printed circuit board **150** of plug the **116** of **FIGS. 4-6**. **FIG. 11** is a schematic side cross-sectional view of a front portion of the printed circuit board **150** and the plug contacts **141-148** shown mating with the jackwire contacts of a mating jack.

As shown in **FIG. 3**, the patch cord **100** includes a cable **109** that has eight insulated conductors **101-108** enclosed in a jacket **110** (the conductors **101-103** and **106-108** are not individually numbered in **FIG. 3**, and conductors **104** and **105** are not visible in **FIG. 3**). The insulated conductors **101-108** may be arranged as four twisted pairs of conductors, with conductors **104** and **105** twisted together to form twisted pair **111** (pair **111** is not visible in **FIG. 3**), conductors **101** and **102** twisted together to form twisted pair **112**, conductors **103** and **106** twisted together to form twisted pair **113**, and conductors **107** and **108** twisted together to form twisted pair **114**. A separator **115** such as a tape separator or a cruciform separator may be provided that separates one or more of the twisted pairs **111-114** from one or more of the other twisted pairs **111-114**. A first plug **116** is attached to a first end of the cable **109** and a second plug **118** is attached to the second end of the cable **109** to form the patch cord **100**. Strain relief features (not shown) such as boots or ferrules, for example, may be attached to each of the plugs **116, 118** which resist the tendency for a longitudinal force applied to the cable **109** to pull the cable **109** out of the plugs **116, 118**.

**FIGS. 4-6** are enlarged views that illustrate the first plug **116** of the patch cord **100**. A rear cap of the plug housing and various wire grooming and wire retention mechanisms are omitted to simplify these drawings. As shown in **FIGS. 4-6**, the communications plug **116** includes a housing **120** that has a bi-level top face **122**, a bottom face **124**, a front face **126**, and a rear opening **128** that receives a rear cap (not shown). A plug latch **132** extends from the bottom face **124**. The top and front faces **122, 126** of the housing **120** include a plurality of longitudinally extending slots **134**. The communications cable **109** (see **FIG. 3**) is received through the rear opening **128**. A rear cap (not shown) that includes a cable aperture locks into place over the rear opening **128** of housing **120** after the communications cable **109** has been inserted therein.

As is also shown in **FIGS. 4-6**, the communications plug **116** further includes a printed circuit board **150** which is disposed within the housing **120**, and a plurality of plug contacts **141-148** in the form of low profile plug blades that are mounted at the forward edge of the printed circuit board **150** so that the blades **141-148** can be accessed through the slots **134** in the top face **122** and front face **126** of the housing **120**. The housing **120** may be made of a suitable insulative plastic material that meets applicable standards with respect to, for example, electrical breakdown resistance and flammability such as, for example, polycarbonate, ABS, ABS/polycarbonate blend or other dielectric molded materials. Any conventional housing **120** may be used that is configured to hold the printed circuit board **150**, and hence the housing **120** is not described in further detail herein.

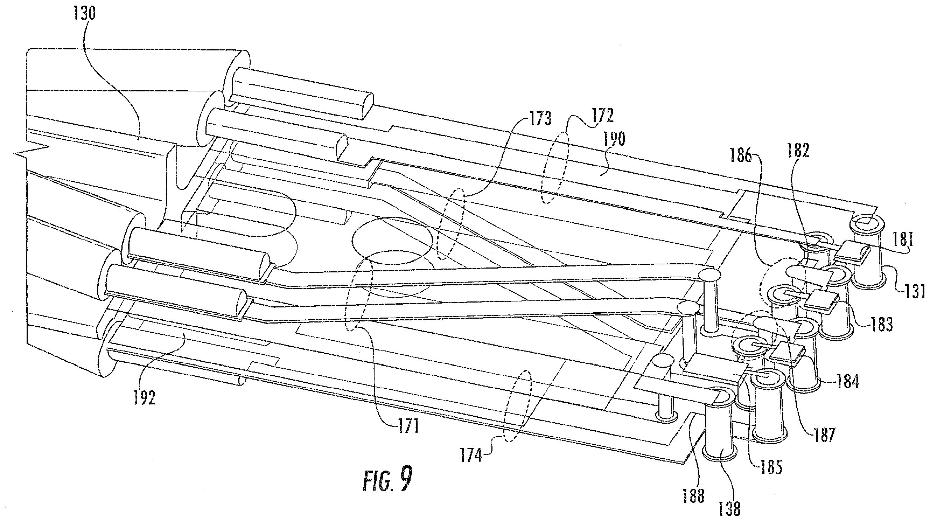

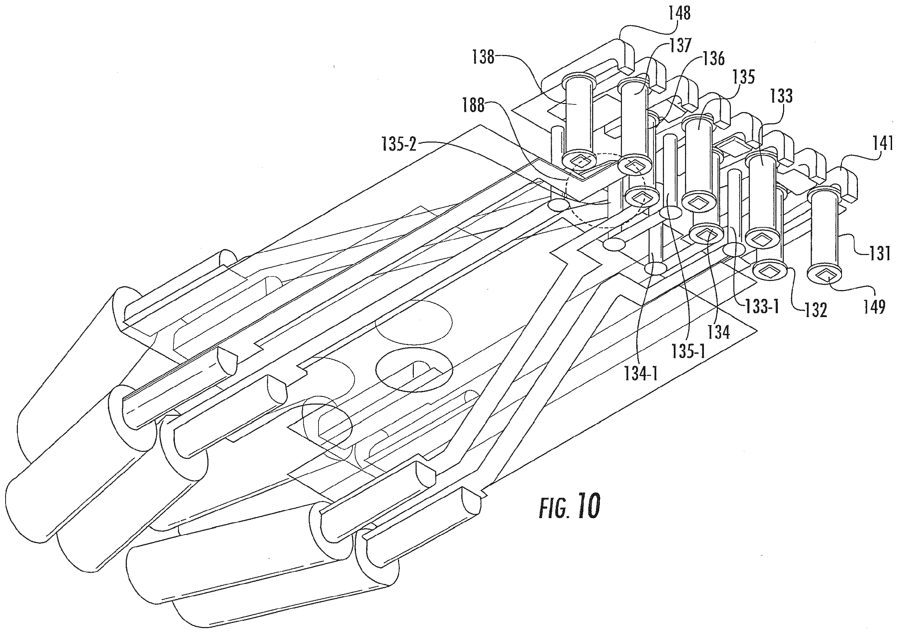

**FIGS. 7** and **8** are enlarged perspective top and bottom views, respectively, of the printed circuit board **150** and the plug blades **141-148** that illustrate these structures in greater detail and that show how the insulated conductors **101-108** of communications cable **109** may be electrically connected to the respective plug blades **141-148** through the printed circuit board **150**. **FIGS. 9** and **10** are enlarged perspective top and bottom views, respectively, of the top and bottom surfaces of the printed circuit board **150** and the plug blades **141-148**. In **FIGS. 9** and **10,** the dielectric portion of the printed circuit board **150** is omitted in order to better illustrate certain features of the printed circuit board **150**. In **FIG. 9**, only the downwardly extending projections of the plug blades **141-148** that are received in the conductive vias **131-138** are shown in order to better illustrate various offending crosstalk circuits that are included in the plug **116**.

The printed circuit board **150** may comprise, for example, a conventional printed circuit board, a specialized printed circuit board (e.g., a flexible printed circuit board) or any other appropriate type of wiring board. In the embodiment of the present invention depicted in **FIGS. 3-10**, the printed circuit board **150** comprises a conventional multi-layer printed circuit board.

As shown in **FIGS. 7-10**, the printed circuit board **150** includes four plated pads **151, 152, 154, 155** on a top surface thereof and an additional four plated pads **153, 156-158** on a bottom surface thereof. The insulation is removed from an end portion of each of the conductors **101-108**, and the metal (e.g., copper) core of each conductor **101-108** may be soldered, welded or otherwise attached to a respective one of the plated pads

151-158. By terminating each of the conductors 101-108 directly onto the plated pads 151-158 without the use of any insulation displacement contacts, insulation piercing contacts or other wire connection contacts, the size of the plug 116 may be reduced. It will also be appreciated that other techniques may be used for terminating the conductors 101-108 to the printed circuit board 150. For example, in other embodiments, a plurality of insulation piercing contacts or insulation displacement contacts may be mounted on the printed circuit board 150 that are used to electrically connect each conductor 101-108 to a respective trace on the printed circuit board 150. It will be appreciated that in other embodiments the conductors 101-108 may attached to the top and bottom surfaces of the printed circuit board 150 according to different groupings than above mentioned. For example, six of the conductors 101-108 may be assigned to the top surface and two of the conductors may be assigned to the bottom surface or vice versa. Alternatively, all of the conductors 101-108 may be mounted exclusively on the bottom surface of the printed circuit board 150 or exclusively on the top surface of the printed circuit board 150.

The conductors 101-108 may be maintained in pairs within the plug 116. A cruciform separator 130 may be included in the rear portion of the housing 120 that separates each pair 111-114 from the other pairs 111-114 in the cable 109 to reduce crosstalk in the plug 116. The conductors 101-108 of each pair 111-114 may be maintained as a twisted pair all of the way from the rear opening 128 of plug 116 up to the printed circuit board 150.

The plug blades 141-148 are configured to make mechanical and electrical contact with respective contacts, such as, for example, spring jackwire contacts, of a mating communications jack. In particular, as shown best in FIGS. 7-8 and 10, each of the eight plug blades 141-148 is mounted at the front portion of the printed circuit board 150. The plug blades 141-148 may be substantially transversely aligned in a side-by-side relationship. Each of the plug blades 141-148 includes a first section that extends forwardly (longitudinally) along a top surface of the printed circuit board 150, a transition section that curves through an angle of approximately ninety degrees and a second section that extends downwardly from the first section along a portion of the front edge of the printed circuit board 150. The transition section may include a curved outer radius that complies with the specification set forth in, for example, IEC 60603-7-4 for industry standards compliant plug blades. The portion of each plug blade 141-148 that is in physical contact with a contact structure (e.g., a jackwire contact) of a mating jack when the plug 116 is fully received within the plug aperture of the mating jack is referred to herein as the "plug-jack mating point" of the plug contact 141-148.

Each of the plug blades 141-148 may be fabricated separately from the printed circuit board 150. In the depicted embodiment, each of the plug blades 141-148 comprise, for example, an elongated metal strip having a length of approximately 140 mils (3.556mm), a width of approximately 20 mils (0.508mm) and a height (i.e., a thickness) of approximately 20 mils (0.508mm). Each plug blade 141-148 may also include a projection 149 that extends downwardly from the bottom surface of the first section of the plug blade (see FIGS. 9-10). The printed circuit board 150 includes eight metal-plated vias 131-138 that are arranged in two rows along the front edge thereof. The projections 149 of each plug blade 141-148 is received within a respective one of the metal-plated vias 131-138 where it may be press-fit, welded or soldered into place to mount the plug blades 141-148 on the printed circuit board 150.

The plug blades 141-148 may be mounted to the printed circuit board 150 in other ways. For example, in other embodiments, elongated contact pads may be provided on the top surface of the printed circuit board 150 and each plug blade 141-148 may be welded or soldered to a respective one of these contact pads. It will be appreciated that many other attachment mechanisms may be used. Further embodiments that include plug blades that are soldered to contact pads are discussed below.

Turning again to FIGS. 7-10 it can be seen that a plurality of conductive paths 161-168 are provided on the top and bottom surfaces of the printed circuit board 150. Each of these conductive paths 161-168 electrically connects one of the plated pads 151-158 to a respective one of the metal-plated vias 131-138 so as to provide a conductive path between each of the conductors 101-108 that are terminated onto the plated pads 151-158 and a respective one of the plug blades 141-148 that are mounted in the metal-plated vias 131-138. Each conductive path 161-168 may comprise, for example, one or more conductive traces that are provided on one or more layers of the printed circuit board 150. When a conductive path 161-168 includes conductive traces that are on multiple layers of the printed circuit board 150 (i.e., conductive paths 163-165 and 168 in the depicted embodiment), metal-plated or metal-filled through holes (or other layer-transferring structures known to those skilled in this art) may be provided that provide an electrical connection between the conductive traces on different layers of the printed circuit board 150.

A total of four differential transmission lines 171-174 are provided through the plug 116. The first differential transmission line 171 includes the end portions of conductors 104 and 105, the plated pads 154 and 155, the conductive paths 164 and 165, the plug blades 144 and 145, and the metal-plated vias 134, 135. The second differential transmission line 172 includes the end portions of conductors 101 and 102, the plated pads 151 and 152, the conductive paths 161 and 162, the plug blades 141 and 142, and the metal-plated vias 131, 132. The third differential transmission line 173 includes the end portions of conductors 103 and 106, the plated pads 153 and 156, the conductive paths 163 and 166, the plug blades 143 and 146, and the metal-plated vias 133, 136.

The fourth differential transmission line **174** includes the end portions of conductors **107** and **108**, the plated pads **157** and **158**, the conductive paths **167** and **168**, the plug blades **147** and **148**, and the metal-plated vias **137, 38**. As shown in **FIGS. 7-10**, the two conductive traces **161-168** that form each of the differential transmission lines **171-174** are generally run together, side-by-side, on the printed circuit board **150**, which may provide improved impedance matching.

A plurality of offending crosstalk circuits are also included on the printed circuit board **150**. As noted above, "offending" crosstalk unavoidably arises when the industry standardized RJ-45 plug-jack interface is used due to the unequal coupling that occurs between the four differential transmission lines through RJ-45 plugs and jacks in the plug-jack mating region of the plug contacts. In order to reduce the impact of this offending crosstalk, communications jacks were developed in the early 1990s that included circuits that introduced compensating crosstalk that was used to cancel much of the "offending" crosstalk that was being introduced in the plug-jack mating region. In particular, in order to cancel the "offending" crosstalk that is generated in a plug-jack connector because a first conductor of a first differential pair inductively and/or capacitively couples more heavily with a first of the two conductors of a second differential pair than does the second conductor of the first differential pair, jacks were designed so that the second conductor of the first differential pair would capacitively and/or inductively couple with the first of the two conductors of the second differential pair later in the jack to provide a "compensating" crosstalk signal. As the first and second conductors of the differential pair carry equal magnitude, but opposite phase signals, so long as the magnitude of the "compensating" crosstalk signal that is induced in such a fashion is equal to the magnitude of the "offending" crosstalk signal, then the compensating crosstalk signal that is introduced later in the jack may substantially cancel out the offending crosstalk signal. As noted above, multi-stage crosstalk compensation techniques have also been developed where two (or more) crosstalk stages having alternating polarities are provided in the jack, which may provide enhanced crosstalk compensation, particularly for higher frequency signals, as is discussed in the above-referenced U.S. Patent No. 5,997,358.

In order to ensure that plugs and jacks manufactured by different vendors will work well together, the industry standards specify amounts of offending crosstalk that must be generated between the various differential pair combinations in an RJ-45 plug for that plug to be industry-standards compliant. Thus, while it is now possible to manufacture RJ-45 plugs that exhibit much lower levels of offending crosstalk, it is still necessary to ensure that RJ-45 plugs inject the industry-standardized amounts of offending crosstalk between the differential pairs so that backwards compatibility will be maintained with the installed base of RJ-45 plugs and jacks.

Pursuant to embodiments of the present invention, RJ-45 plugs are provided such as plug **116** that use PCB-mounted low profile plug blades. The terminations of the conductors **101-108** onto the printed circuit board **150**, the routings of the conductive paths **161-168**, and the low profile plug blades **141-148** are designed so that the amount of offending crosstalk that is generated between the differential pairs **171-174** by these features may be less, and perhaps significantly, less, than the offending crosstalk levels specified in the relevant industry-standards documents. A plurality of offending crosstalk circuits are then used to inject additional offending crosstalk between the pairs in order to bring the RJ-45 plug **116** into compliance with these industry standards documents.

The above-described approach may be beneficial, for example, because if everything else is held equal, more effective crosstalk cancellation may generally be achieved the closer the point of injection of the compensating crosstalk (or at least the first stage of compensating crosstalk) is to the point where the offending crosstalk is injected. The RJ-45 plug **116** is designed to generate low levels of offending crosstalk in the back portion of the plug (i.e., in portions of the plug **116** that are at longer electrical delays from the plug-jack mating regions of the plug blades **141-148**). Furthermore, a plurality of offending crosstalk circuits are provided at very short delays from the plug-jack mating regions of the plug blades **141-148** which are used to bring the offending crosstalk to the level required to comply with the industry standards. In this manner, a large portion of the crosstalk generated in the plug **116** is generated at a very small delay from the plug-jack mating regions of the plug blades **141-148**. This may allow for more effective cancellation of the offending crosstalk in a mating jack.

In particular, as shown in **FIG. 9**, a total of five offending crosstalk capacitors **181-185** are provided adjacent the plug blades **141-148**. Capacitor **181** injects offending crosstalk between plug blades **142** and **143** (i.e., between differential transmission lines **172** and **173**), capacitor **182** injects additional offending crosstalk between plug blades **142** and **143**, capacitor **183** injects offending crosstalk between plug blades **143** and **144** (i.e., between differential transmission lines **171** and **173**), capacitor **184** injects offending crosstalk between plug blades **145** and **146** (i.e., between differential transmission lines **171** and **173**), and capacitor **185** injects offending crosstalk between plug blades **146** and **147** (i.e., between differential transmission lines **173** and **174**).

As can be seen in **FIG. 9**, each of the five offending crosstalk capacitors **181-185** are configured to inject offending crosstalk at a location that is very near to the plug-jack mating region of each plug blade **141-148**. In particular, the electrodes for each crosstalk capacitor **181-185** connect to the top edges of the conductive vias **132-137**. Thus, the offending crosstalk that is generated by each offending crosstalk capacitor **181-185** is injected at the underside of the plug blades

142-147.

Moreover, as shown in **FIG. 11**, the point where the offending crosstalk generated by capacitors 181-185 is injected into the differential transmission lines 171-174 is almost at the plug-jack mating point of each respective plug blade 142-147. In particular, **FIG. 11** is a schematic side cross-sectional view of the front portion of printed circuit board **150** (and plug blade **143**) that shows where the jack contacts **142', 143'** of a particular mating RJ-45 jack will be positioned when the plug **116** is fully received within the plug aperture of the jack. As shown in **FIG. 11**, the jack contacts may be aligned in two transverse rows, with four jack contacts in each transverse row (only jack contacts **142', 143'** are visible in the side view of **FIG. 11**). The jackwire contacts **142', 143'** in the rear transverse row (i.e., the row that includes jackwire contact **142'**) physically contact their respective plug blades (e.g., plug blade **142** for jack contact **142'**) directly over the respective conductive vias **132, 134, 136, 138**. Thus, a signal that enters the back end of plug **116** need only flow through the thickness of plug blade **142** to reach the jackwire contact **142'** (since the plug-jack mating point is directly opposite the location where the signal will be injected from the conductive via **132** into the plug blade **142**. This distance is denoted by the arrow labeled "**D**" in **FIG. 11**. As the plug blade **142** may be quite thin (since low profile plug blades are used that may be, for example, about 10-20 mils (0.254 - 0.508mm) thick), the offending crosstalk that is injected at the top of conductive via **132** is injected at a very short delay from the plug-jack mating region of plug blade **142** (i.e., at a delay corresponding to the time that the signal requires to traverse the thickness "D" of the plug blade **142**). Similarly, the jackwire contacts in the front transverse row (i.e., the row that includes jackwire contact **143'**) physically contact their respective plug blades (e.g., plug blade **143** for jack contact **143'**) directly over the respective conductive vias **131, 133, 135, 137**. Thus, a signal that enters the back end of plug **116** need only flow through the thickness of plug blade **143** to reach the jackwire contact **143'** (since the plug-jack mating point is directly opposite the location where the signal will be injected from the conductive via **133** into the plug blade **143**. Thus, the offending crosstalk that is injected at the top of conductive via **133** is also injected at a very short delay from the plug-jack mating region of plug blade **143** (i.e., at a delay corresponding to the time that the signal requires to traverse the thickness of the plug blade **143**). As noted above, communications jacks may be designed that exhibit very high levels of crosstalk cancellation, even for high frequency signals, when the offending crosstalk is mostly introduced at very shot delays as is the case in the plug **116**. The advantages of injecting much of the offending crosstalk near or even after the plug-jack mating point is discussed in detail in U.S. Patent No. 8,197,286, issued June 12, 2012. It will be appreciated that the plugs described herein and complimentary jacks may be used to implement the principals set forth in U.S. Patent No. 8,197,286 for matching the locations of offending and compensating crosstalk vectors in mated plug-jack combinations.

Additionally, three offending crosstalk inductive coupling sections **186-188** are provided in the printed circuit board **150**. In particular, as shown best in **FIGS. 9** and **10**, the conductive path **163** includes an additional conductive via **133-1**. This additional conductive via **133-1** is used (instead of conductive via **133**) to transfer signals from the trace on the bottom side of printed circuit board **150** that is part of conductive path **163** to the top side of the printed circuit board **150**. The conductive via **133-1** may be longitudinally aligned with conductive via **133**, and may be transversely aligned with conductive via **134**. By moving the vertical signal-current carrying path for conductive path **163** rearwardly by using conductive via **133-1** instead of conductive via **133** for the current-carrying path, the vertical current-carrying path for conductive path **163** is moved closer to conductive via **134** and farther away from conductive via **135**. The net effect of this change is to significantly increase the offending inductive crosstalk that is generated between differential transmission lines **171** and **173**, as the currents flowing through conductive vias **133-1** and **134** will couple heavily (due to their close proximity), and the coupling between conductive via **133-1** and conductive via **135** will be low due to the increased distance therebetween. Thus, the conductive vias **133-1** and **134** together form a first offending crosstalk inductive coupling section **186** which generates offending inductive crosstalk between differential transmission lines **171** and **173**.

In a similar fashion, the conductive path **165** includes an additional conductive via **135-1**. This additional conductive via **135-1** is used instead of conductive via **135** to transfer signals from the trace on the bottom side of printed circuit board **150** that is part of conductive path **165** to the top side of the printed circuit board **150**. The additional conductive via **135-1** is longitudinally aligned with conductive via **135**, and is transversely aligned with conductive via **136**. By moving the vertical signal-current carrying path for conductive path **135** rearwardly by using conductive via **135-1** instead of conductive via **135** for the current-carrying path, the vertical current-carrying path for conductive path **135** is moved closer to conductive via **136** and farther away from conductive via **133**. The net effect of this change is to significantly increase the offending inductive crosstalk that is generated between differential transmission lines **171** and **173**, as the currents flowing through conductive vias **135-1** and **136** will couple heavily (due to their close proximity), and the coupling between conductive vias **135-1** and **133** will be low due to the increased distance therebetween. Thus, the conductive vias **135-1** and **136** together form a second offending crosstalk inductive coupling section **187** which generates offending inductive crosstalk between differential transmission lines **171** and **173**.

The offending inductive crosstalk circuits **186**, **187** inject the offending crosstalk close to the plug-jack mating points on the plug blades **143-146** of differential transmission lines **171, 173** (albeit not as close as the capacitive offending crosstalk circuits **181-185**). The offending inductive crosstalk is generated in the vertical conductive vias **133-1, 134, 135-1, 136** because higher levels of inductive coupling can generally be generated in the conductive via structures than can be generated, for example, through the use of inductively coupling side-by-side conductive traces on the printed circuit board **150**. Note that two additional conductive vias **134-1** and **135-2** are provided through the printed circuit board **150**. The conductive vias **134-1** and **135-2** are provided to transfer the conductive paths **164** and **165**, respectively, from the top surface to the bottom surface of printed circuit board **150** so that current will flow through conductive vias **134** and **135-1**, as is necessary for proper operation of the offending inductive crosstalk circuits **186, 187**, and to also arrange the direction of current flow through conductive vias **133-1, 134, 135-1, 136** so that inductive coupling will occur between vias **133-1** and **134** and between vias **135-1** and **136**. Conductive traces which connect vias **135-1** and **135-2**, and which connect vias **134** and **134-1**, provide additional inductive coupling to adjacent sections of conductive paths **166** and **163**, respectively, thereby generating additional inductive offending crosstalk between pairs 1 and 3.

While larger capacitors could be used in offending crosstalk circuits **183-184** to generate the industry standard specified amounts of offending crosstalk between differential transmission lines **171** and **173**, if only capacitive offending crosstalk is used, it may be more difficult to adequately compensate for both NEXT and FEXT in a jack that mates with plug **116**. By providing the inductive crosstalk compensation circuits **186, 187**, it has been found that more effective cancelling of both NEXT and FEXT may be achieved in the mating jack.

Additionally, as shown best in **FIG. 10**, a third offending inductive crosstalk circuit **188** is provided in the form of a section on the bottom side of the printed circuit board where conductive paths **166** and **167** are run side-by-side. Offending inductive crosstalk circuit **188** injects offending inductive crosstalk between transmission lines **173** and **174** in order to meet the specified offending FEXT requirements in the Category 6a standard.

As noted above, the plug **116** may be designed to mostly inject the industry standardized levels of offending crosstalk between the differential transmission lines at locations close to the plug-jack mating points of plug blades **141-148**. Various features of plug **116** that may facilitate reducing the amount of offending crosstalk that is injected farther back in the plug **116** will now be described.

First, the conductors **101-108** terminate onto both the top and bottom sides of the printed circuit board **150** (i.e., four conductors terminate onto each side of the printed circuit board **150**). This allows the conductors **101-108** of different differential pairs to be spaced apart a greater distance along the transverse dimension, which reduces crosstalk between the pairs, and also facilitates maintaining the twist in the conductors up to almost the points of termination (which further helps mitigate crosstalk). Likewise, the conductive traces that form the conductive paths **161-168** are arranged in pairs that are generally spaced far apart from each other in order to reduce or minimize coupling between the differential transmission lines **171-174** until those transmission lines reach the front section of the printed circuit board **150** underneath the plug blades **141-148**.

Additionally, the back end of plug **116** includes a cruciform separator **130** that spaces the conductor pairs **101, 102; 103, 106; 104, 105; 107, 108** apart from each other in order to reduce coupling. In some embodiments, the separator **130** may be plated with a conductive material (or formed of a conductive material) in order to enhance its shielding properties.

As is shown in **FIGS. 9** and **10**, a pair of reflection or "image" planes **190, 192** are included in the printed circuit board **150**. The first image plane **190** is located just below a top surface of the printed circuit board **150**, and the second image plane **192** is located just above a bottom surface of the printed circuit board **150**. Each image plane **190, 192** may be implemented as a conductive layer on the printed circuit board **150**. In some embodiments, the image planes **190, 192** may be grounded by, for example, connecting each image plane to a ground wire, drain wire or other ground reference so that each image plane **190, 192** will act as a ground plane. However, in other embodiments, the image planes **190, 192** may not be electrically grounded (i.e., they are left floating electrically). The image planes **190, 192**, whether or not they are electrically grounded, may act as shielding structures that reduce coupling between the portions of conductive traces **161-168** that are on the top side of the printed circuit board **150** and the portions of conductive traces **161-168** that are on the bottom side of the printed circuit board **150**.

The plugs (and patch cords that include such plugs) according to embodiments of the present invention may exhibit outstanding crosstalk performance. As described above, in some embodiments, the plugs may include low profile plug blades. These plug blades may each include a first section that extends longitudinally along a top surface of the printed circuit board (in direct contact with the top surface of the printed circuit board). As described above, the signal current injection point into these first segments of the plug contacts may be in a middle portion of the first segments. This configuration can allow, for example, for shorter signal current carrying paths through the plug blades. This configuration may also allow a staggering of the signal current carrying path through adjacent plug blades. Thus, the signal current-carrying path through each of the plug contacts may be offset in a longitudinal dimension of the plug from the signal current-carrying path of at least an adjacent one of the plug contacts. However, it will be appreciated that in other embodiments longer signal current carrying paths and/or overlapping signal current carrying paths may be provided between adjacent plug blades. For example, in an alternative embodiment the offending inductive crosstalk circuits **186, 187** may be replaced with offending inductive crosstalk circuits that are implemented in adjacent plug blades.

In some embodiments, the plug-jack mating point on at least some of the plug blades may be substantially opposite the point on each plug blade where signal currents are injected into the plug blade from the printed circuit board. This also may result in reducing the length of the signal current carrying paths through the respective plug blades. For example, in some embodiments, a minimum signal current-carrying path through at least some of the first plug contacts (i.e., the minimum distance that the signal current must travel in passing from the printed circuit board to a mating jackwire contact) may be less than twice a height of the first plug contact above a top surface of the printed circuit board.

In some embodiments, each plug contact may comprise a longitudinally extending first segment that extends along a top surface of the printed circuit board and a downwardly extending second segment that extends along a front edge of the printed circuit board. Substantially the entirety of the first segment and the second segment of each plug contact may rest directly on the top surface of the printed circuit board. In some embodiments, the plug blades may extend less than 90 mils (2.286mm) above a top surface of the printed circuit board. In some embodiments, the plug blades may be low profile blades that extend no more than 60 mils (1.524mm) above a top surface of the printed circuit board and may be no more than 30 mils (0.762mm) above a top surface of the printed circuit board.

In some embodiments, the signal current injection points into a first subset of the plug contacts may be aligned in a first transverse row, and the signal current injection points into a second subset of the plug contacts may be aligned in a second row that is offset from the first row. Each plug contact may be mounted in a respective one of a plurality of conductive vias in the printed circuit board through a downwardly extending projection that is provided on each plug contact. These conductive vias may also be aligned in multiple rows so that a first subset of the vias is staggered with respect to a second subset of the vias. In some embodiments, the plug may further include at least one additional conductive via that inductively couples with another conductive via (e.g., a via that is used to mount a plug blade) to form an inductive offending crosstalk circuit.

In some embodiments, at least one offending crosstalk capacitor may be provided that injects offending crosstalk between two of the differential transmission lines through the plug. This capacitor may be implemented on the printed circuit board, and may inject the offending crosstalk substantially at a first interface between a first plug contact and the printed circuit board and at a second interface between a second plug contact and the printed circuit board. In other embodiments, the offending crosstalk capacitor may be configured to inject offending crosstalk between the differential pairs at a point in time that is after the point in time when a signal transmitted through the plug contact to a contact of a mating jack reaches the contact of the mating jack.

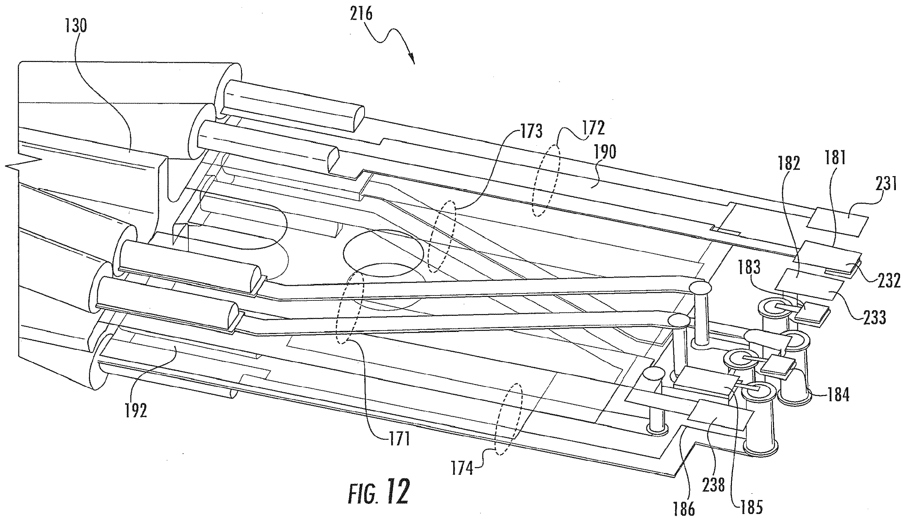

**FIG. 12** is a top, partial perspective view of a plug **216** according to further embodiments of the present invention. The plug **216** may be identical to the plug **116** described above with reference to **FIGS. 3-11**, except that in the plug **216**, the conductive vias **131, 132, 133** and **138** have been omitted and replaced with contact pads **231, 232, 233** and **238**, respectively. Plug blades **141, 142, 143** and **148** (see **FIG. 10**) are soldered to the respective contact pads **231, 232, 233** and **238**. This may reduce capacitive coupling between the conductive vias **131-138** that the plug blades are mounted in, as some of the conductive vias are omitted. In particular, in some designs the conductive vias **131-138** may not be staggered sufficiently (in transverse rows) in order to become "neutral" in terms of crosstalk generation. As such, offending crosstalk may be generated between adjacent conductive vias. If some of the conductive vias are removed, this offending coupling is eliminated for those vias. Additional coupling may be provided, for example, by increasing the capacitance of the offending crosstalk circuits **181-185** in order to ensure that the industry standardized amounts of offending crosstalk are generated in the plug. This may facilitate generally increasing the degree to which the offending crosstalk is pushed forward in time toward (or even after) the plug-jack mating point. It will be appreciated that any or all of the conductive vias **131-138** may be omitted and replaced with, for example, contact pads such as contact pads **231, 232, 233** and **238**.

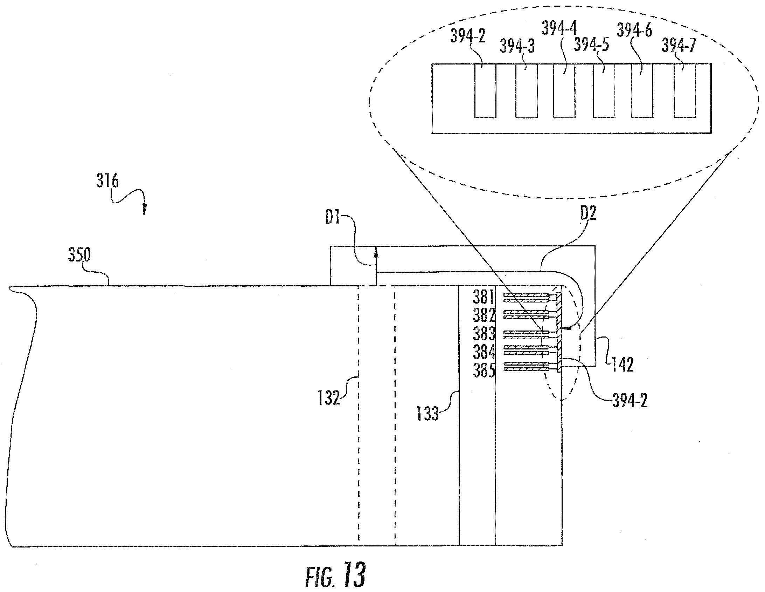

**FIG. 13** is a schematic side view of the front portion of a printed circuit board **350** and plug contacts (only plug contact **142** is visible in the side view of **FIG. 13**) of a plug **316** according to still further embodiments of the present invention. The plug **316** may be identical to the plug **116** described above with reference to **FIGS. 3-11**, except as noted below.

As shown in **FIG. 13**, six downwardly extending, rectangular contact pads **394-2** through **394-7** (only contact pad **394-2** is visible in the side cross-sectional view **FIG. 13**; the callout in **FIG. 13** is a front view of the printed circuit board **350** with the plug contacts removed that shows all of contact pads **394-2** through **394-7**) are disposed along the front edge of the printed circuit board **350**. The second, downwardly extending segment of each plug contact **142-147** may rest directly on a respective one of the six contact pads **394-2** through **394-7**, thereby electrically connecting the second (distal) end of each plug blade **142-147** to the printed circuit board **350**. The offending crosstalk capacitors **181-185** of the plug **116** of **FIGS. 3-11** may be replaced with capacitors **381-385**. Each capacitor **381-385** has a first electrode that is electrically connected to a first of the contact pads **394-2** through **394-7** and a second electrode that is electrically connected to a second of the contact pads **394-2** through **394-7**. In particular, capacitor **381** is electrically connected to contact pads **394-2** and **394-3** and injects offending crosstalk between blades **142** and **143** (i.e., between differential transmission lines **172** and **173**), capacitor **382** is also electrically connected to contact pads **394-2** and **394-3** and injects offending crosstalk between blades **142** and **143** (i.e., between differential transmission lines **172** and **173**), capacitor **383** is electrically connected to contact pads **394-3** and **394-4** and injects additional offending crosstalk between blades **143** and **144** (i.e., between differential transmission lines **171** and **173**), capacitor **384** is electrically connected to contact pads **394-5** and **394-6** and injects offending crosstalk between blades **145** and **146** (i.e., between differential transmission lines **171** and **173**), and capacitor **385** is electrically connected to contact pads **394-6** and **394-7** and injects offending crosstalk between blades **146** and **147** (i.e., between differential transmission lines **173** and **174**).

The printed circuit board **350** is very similar to the printed circuit board **150**, with the differences being the inclusion of the six contact pads **394-2** through **394-7** and the replacement of capacitors **181-185** with capacitors **381-385** which are similar, but which connect at a different location to the differential transmission lines **171-174** through the plug **316**. This difference in location impacts the time at which the offending capacitive crosstalk is injected onto each differential transmission line **171-174**. In particular, as shown in **FIG. 13**, a signal that enters the back end of a plug that includes printed circuit board **350** will pass through via **132** and into plug contact **142**. After travelling a distance D1 through plug contact **142**, this signal will pass from plug blade **142** onto a jackwire contact of a mating communications jack. The signal will also pass to the front of plug blade **142** where it will capacitively couple via capacitor **381** with adjacent plug blade **143**. However, since the distance from the top of via **132** to capacitor **381** (distance D2 in **FIG. 13**) is substantially greater than distance D1, the net effect is that the offending crosstalk generated by capacitor **381** (which couples energy between plug blades **142** and **143**) will appear after the plug-jack mating point, since the signal will have already passed into the jack (along the arrow labeled D1 in **FIG. 13**) before the signal reaches capacitor **381**.

As noted above, improved performance may be obtained in some embodiments if the offending crosstalk in the plug is injected near the plug-jack mating point or even after the plug-jack mating point (for signals travelling from the plug to the jack). The advantages of injecting much of the offending crosstalk near or even after the plug-jack mating point is discussed in detail in the above-discussed U.S. Patent No. 8,197,286. As discussed in this patent, jacks may be designed that have first stage compensating crosstalk injection circuits that will inject compensating crosstalk at approximately the same time that the offending crosstalk is injected. This may cancel the offending crosstalk at all frequencies, providing much higher levels of crosstalk compensation. The printed circuit board **350** may be used to implement the techniques disclosed in U.S. Patent No. 8,197,286 where much of the offending crosstalk can be designed so that it is injected after the plug-jack mating point, and preferably at the same time delay as compensating crosstalk having the opposite polarity, in order to cancel much of the offending crosstalk at all frequencies, thereby obtaining improved levels of crosstalk cancellation.

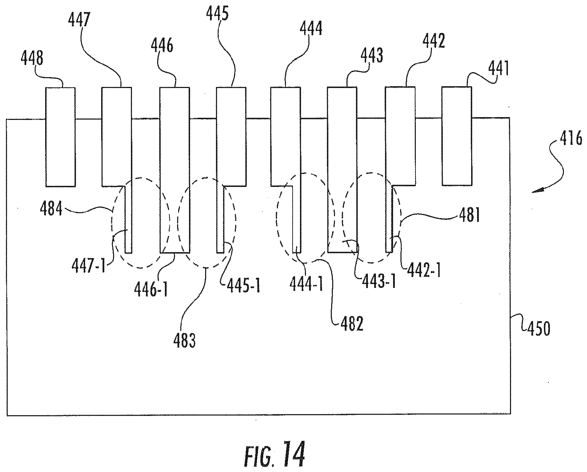

**FIG. 14** is a schematic front view of portions of a plug **416** according to further embodiments of the present invention. In particular, **FIG. 14** pictures the plug contacts **441-448** and the printed circuit board **450** of plug **416**.

The plug **416** may be identical to the plug **116** except for in the following ways. First, the plug blades **142-147** of plug **116** are replaced with the plug blades **442-447** depicted in **FIG. 14** (plug blades **441** and **448** remain unchanged from plug blades **141** and **148** in plug **116**). The plug blades **442-447** may be identical to the plug blades **142-147** except that the plug blades **442-447** include plates **442-1** through **447-1** that extend downwardly from the second segment of plug blades **442-447**. These plates **442-1** through **447-1** may be used as offending crosstalk capacitors. In particular, plates **442-1** and **443-1** form a first offending crosstalk capacitor **481**, plates **443-1** and **444-1** form a second offending crosstalk capacitor **482**, plates **445-1** and **446-1** form a third offending crosstalk capacitor **483**, and plates **446-1** and **447-1** form a fourth offending crosstalk capacitor **484**. As the capacitors **481-484** are located at the distal end of the plug blades and are far removed from the signal current-carrying path through the plug blades **441-448** (which will be identical to the signal current-carrying paths in plug blades **141-148** as discussed above), the capacitors **481-484** may inject offending crosstalk after the plug-jack mating point.

As is further shown in **FIG. 14**, plates **443-1** and **446-1** are thick plates that have the same width (in the transverse dimension of the plug) as the remainder of the plug blade, while plates **442-1, 444-1, 445-1** and **447-1** are thin plates that have widths that are substantially smaller than the width of the remainder of the plug blades. Thinner plates **442-1, 444-1, 445-1** and **447-1** are used on plug blades that are adjacent to another plug blade of the same differential pair, as this may improve the return loss performance of the plug. For example, the plate **442-1** that extends downwardly from plug blade **442** is a thin plate that is positioned to be close to plate **443-1** and to be farther away from plug blade **441**. In this manner, an offending crosstalk capacitor **481** is formed, without substantially increasing the capacitive loading between plug blades **441** and **442**. Additional capacitive loading between the plug blades **441** and **442** (which are part of the same differential transmission line **172**) may negatively impact the return loss in differential transmission line **172**. Thus, by using the thin plate **442-1** it may be possible to provide an offending crosstalk capacitor between plug blades **442** and **443** without substantially increasing the capacitive loading between plug blades **441** and **442**. The use of thin plates **444-1, 445-1** and **447-1** similarly provides offending crosstalk capacitors **482-484** while limiting the amount of additional capacitive loading between the plug blades of differential transmission lines **171** and **174**. Thinner extensions need not be provided on plug blades **443** and **446** as these blades are on the "split pair" and hence do not substantially capacitively couple to each other.

The present invention is not limited to the illustrated embodiments discussed above; rather, these embodiments are intended to fully and completely disclose the invention to those skilled in this art. In the drawings, like numbers refer to like elements throughout. Thicknesses and dimensions of some components may be exaggerated for clarity.

Spatially relative terms, such as "top," "bottom," "side," "upper," "lower" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "under" or "beneath" other elements or features would then be oriented "over" the other elements or features. Thus, the exemplary term "under" can encompass both an orientation of over and under. The device may be otherwise oriented (rotated 90 degrees or at other orientations) and the spatially relative descriptors used herein interpreted accordingly.

Herein, the term "signal current carrying path" is used to refer to a current carrying path on which an information signal will travel on its way from the input to the output of a communications plug. Signal current carrying paths may be formed by cascading one or more conductive traces on a wiring board, metal-filled apertures that physically and electrically connect conductive traces on different layers of a printed circuit board, portions of plug blades, conductive pads, and/or various other electrically conductive components over which an information signal may be transmitted. Branches that extend from a signal current carrying path and then dead end such as, for example, a branch from the signal current carrying path that forms one of the electrodes of an inter-digitated finger or plate capacitor, are not considered part of the signal current carrying path, even though these branches are electrically connected to the signal current carrying path. While a small amount of current will flow into such dead end branches, the current that flows into these dead end branches generally does not flow to the output of the plug that corresponds to the input of the plug that receives the input information signal.

Well-known functions or constructions may not be described in detail for brevity and/or clarity. As used herein the expression "and/or" includes any and all combinations of one or more of the associated listed items.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises", "comprising", "includes" and/or "including" when used in this specification, specify the presence of stated features, integers, steps, operations, elements, and/or components, but do not preclude the presence or addition of one or more other features, integers, steps, operations, elements, components, and/or groups thereof.

All of the above-described embodiments may be combined in any way to provide a plurality of additional embodiments.

The foregoing is illustrative of the present invention and is not to be construed as limiting thereof. Although exemplary embodiments of this invention have been described, those skilled in the art will readily appreciate that many modifications are possible in the exemplary embodiments without materially departing from the novel teachings and advantages of this invention. Accordingly, all such modifications are intended to be included within the scope of this invention as defined in the claims. The invention is defined by the following claims.

## Claims

**1.** A patch cord (100) comprising:

a communications cable (109) that includes at least a first conductor (101), a second conductor (102), a third conductor (103) and a fourth conductor (104); and
a plug (116) that is attached to the communications cable (109), the plug comprising:

a housing (120) that receives the communications cable (109);
a printed circuit board (150) that is at least partly within the housing (120);
a first plug contact (141), a second plug contact (142), a third plug contact (143) and a fourth plug contact (144) that each are at least partially within the housing (120);
a first conductive path that connects the first conductor (101) to the first plug contact (141), a second conductive path that connects the second conductor (102) to the second plug contact (142), a third conductive path that connects the third conductor (103) to the third plug contact (143), and a fourth conductive path that connects the fourth conductor (104) to the fourth plug contact (144),
wherein the first and second conductors (101, 102), the first and second conductive paths, and the first and second plug contacts (141, 142) form a first differential transmission line through the plug (116) and the third and fourth conductors (103, 104), the third and fourth conductive paths, and the third and fourth plug contacts (143, 144) form a second differential transmission line through the plug (116),
wherein each of the first through fourth plug contacts (141 - 144) has a first segment that extends longitudinally along a first surface of the printed circuit board (150); and
wherein respective signal current injection points from the printed circuit board (150) into the first and third plug contacts (141, 143) are aligned in a first transverse row, and the respective signal current injection points from the printed circuit board (150) into the second and fourth plug contacts (142, 144) are offset from the first transverse row;
**characterized in that** the signal current injection points from the printed circuit board (150) into the first segment of at least some of the first through fourth plug contacts (141 - 144) are into middle portions of their respective first segments.

2. The patch cord of Claim 1, wherein the plug-jack mating point on the first plug contact (141) is on a first side of the first plug contact and wherein the signal current injection point into the first plug contact is on a second side of the first plug contact that is opposite the first side and is also substantially opposite the plug-jack mating point on the first plug contact.

3. The patch cord of Claim1 or Claim 2, wherein substantially the entirety of the first segment of the first plug contact rests directly on the first surface of the printed circuit board (150).

4. The patch cord of any one of Claims 1 to 3, wherein a minimum signal current-carrying path through the first plug contact (141) is less than twice a height of the first plug contact above the first surface of the printed circuit board (150).

5. The patch cord of any preceding Claim, wherein the first through fourth plug contacts (141 - 144) extend no more than 30 mils (0.762mm) above the first surface of the printed circuit board (150).

6. The patch cord of any preceding Claim, wherein the respective signal current injection points into the second and fourth plug contacts (142, 144) are aligned in a second transverse row.

7. The patch cord of any preceding Claim, wherein each of the first through fourth plug contacts (141 - 144) has a respective second segment that extends downwardly from an end of the respective first segments along a front edge of the printed circuit board (150).

8. The patch cord of any preceding Claim, wherein the printed circuit board (150) includes a plurality of conductive vias (131 - 134), wherein each of the first through fourth plug contacts (141 - 144) has a projection that is received within a respective one of the conductive vias, and wherein the conductive vias (131, 133) that receive the projections of the first and third plug contacts (141, 143) are aligned in a first row, and the conductive vias (132, 134) that receive the projections of the second and fourth plug contacts (142, 144) are offset from the first row.

9. The patch cord of Claim 8, further comprising:

a fifth via (135) that is part of the first conductive path that is located in a portion of the printed circuit board (150) that is underneath the first through fourth plug contacts (141 - 144), wherein the fifth via (135) is part of an offending crosstalk circuit; and
a sixth via (136) that is part of the third conductive path that is located in the portion of the printed circuit board (150) that is underneath the first through fourth plug contacts (141 - 144);
wherein the offending crosstalk circuit is a first offending crosstalk circuit that injects inductive crosstalk between the first conductive path and the fourth conductive path, the plug (116) further comprising a second offending crosstalk circuit that includes the sixth via (136) that injects inductive crosstalk between the second conductive path and the third conductive path.

10. The patch cord of any preceding Claim, wherein the plug (116) comprises an RJ-45 plug that further includes fifth and sixth plug contacts (145, 146) that are part of a third differential transmission line through the plug and seventh and eighth plug contacts (147, 148) that are part of a fourth differential transmission line through the plug, wherein the first, third, fifth and seventh plug contacts (141, 143, 145, 147) are mounted in respective first through fourth conductive vias (131 - 134) that are substantially aligned in a first row and the second, fourth, sixth and eighth plug contacts (142, 144, 146, 148) are mounted in respective fifth through eighth conductive vias (135 - 138) that are substantially aligned in a second row that is offset from the first row.

**11.** The patch cord of any preceding Claim, wherein the signal current-carrying path through each of the first through fourth plug contacts (141 - 144) is offset in a longitudinal dimension of the plug (116) from the signal current-carrying path of at least an adjacent one of the first through fourth plug contacts.

**12.** The patch cord of any preceding Claim, further comprising an offending crosstalk capacitor (181) that injects offending crosstalk between the second conductive path and the third conductive path.

**13.** The patch cord of Claim 12, wherein the offending crosstalk capacitor (181) comprises a printed circuit board capacitor that injects offending crosstalk onto the second conductive path substantially at a first interface between the second plug contact (142) and the printed circuit board (150), and wherein the offending crosstalk capacitor (181) injects offending crosstalk onto the third conductive path substantially at a second interface between the third plug contact (143) and the printed circuit board (150).

**14.** The patch cord of Claim 12 or Claim 13, wherein the offending crosstalk capacitor (181) is configured to inject offending crosstalk onto the second conductive path at a point in time that is after the point in time when a signal transmitted through the second plug contact (142) to a contact of a mating jack reaches the contact of the mating jack.

**Patentansprüche**

**1.** Patchkabel (100), das Folgendes umfasst:

ein Kommunikationskabel (109), das mindestens einen ersten Leiter (101), einen zweiten Leiter (102), einen dritten Leiter (103) und einen vierten Leiter (104) umfasst; und einen Stecker (116), der an dem Kommunikationskabel (109) angebracht ist, wobei der Stecker Folgendes umfasst:

ein Gehäuse (120), das das Kommunikationskabel (109) aufnimmt; eine Leiterplatte (150), die mindestens teilweise innerhalb des Gehäuses (120) angeordnet ist; einen ersten Steckkontakt (141), einen zweiten Steckkontakt (142), einen dritten Steckkontakt (143) und einen vierten Steckkontakt (144), die sich jeweils mindestens teilweise innerhalb des Gehäuses (120) befinden; einen ersten leitfähigen Pfad, der den ersten Leiter (101) mit dem ersten Steckkontakt (141) verbindet, einen zweiten leitfähigen Pfad, der den zweiten Leiter (102) mit dem zweiten Steckkontakt (142) verbindet, einen dritten leitfähigen Pfad, der den dritten Leiter (103) mit dem dritten Steckkontakt (143) verbindet, und einen vierten leitfähigen Pfad, der den vierten Leiter (104) mit dem vierten Steckkontakt (144) verbindet,

wobei der erste und der zweite Leiter (101, 102), der erste und der zweite leitfähige Pfad und der erste und der zweite Steckkontakt (141, 142) eine erste differentielle Übertragungsleitung durch den Stecker (116) bilden und der dritte und der vierte Leiter (103, 104), der dritte und der vierte leitfähige Pfad und der dritte und der vierte Steckkontakt (143, 144) eine zweite differentielle Übertragungsleitung durch den Stecker (116) bilden,

wobei jeder der ersten bis vierten Steckkontakte (141 - 144) ein erstes Segment aufweist, das sich in Längsrichtung entlang einer ersten Oberfläche der Leiterplatte (150) erstreckt; und

wobei die jeweiligen Signalstrominjektionspunkte von der Leiterplatte (150) in die ersten und dritten Steckkontakte (141, 143) in einer ersten Querreihe ausgerichtet sind, und die jeweiligen Signalstrominjektionspunkte von der Leiterplatte (150) in die zweiten und vierten Steckkontakte (142, 144) von der ersten Querreihe versetzt sind; **dadurch gekennzeichnet, dass** die Signalstrominjektionspunkte von der Leiterplatte (150) in das erste Segment von mindestens einigen der ersten bis vierten Steckkontakte (141 - 144) in Mittelabschnitten ihrer jeweiligen ersten Segmente angeordnet sind.

**2.** Patchkabel nach Anspruch 1, wobei der Steckerbuchsen-Verbindungspunkt an dem ersten Steckkontakt (141) an einer ersten Seite des ersten Steckkontakts liegt und wobei der Signalstrominjektionspunkt in den ersten Steckkontakt auf einer zweiten Seite des ersten Steckkontakts liegt, die der ersten Seite gegenüberliegt und auch im Wesentlichen dem Steckerbuchsen-Gegenkontakt am ersten Steckkontakt gegenüberliegt.

**3.** Patchkabel nach Anspruch 1 oder 2, wobei im Wesentlichen die Gesamtheit des ersten Segments des ersten Steckkontakts direkt auf der ersten Oberfläche der Leiterplatte (150) aufliegt.

**4.** Patchkabel nach einem der Ansprüche 1 bis 3, wobei ein minimaler Signalstromführungspfad durch den ersten Steckkontakt (141) kleiner ist als das Doppelte einer Höhe des ersten Steckkontakts über der ersten Oberfläche der Leiterplatte (150).

**5.** Patchkabel nach einem der vorhergehenden Ansprüche, wobei sich die ersten bis vierten Steckkontakte (141 - 144) nicht mehr als 30 Mil (0,762 mm) über der ersten Oberfläche der Leiterplatte (150) erstrecken.

**6.** Patchkabel nach einem der vorhergehenden Ansprüche, wobei die jeweiligen Signalstrominjektionspunkte in die zweiten und vierten Steckkontakte (142, 144) in einer zweiten Querreihe ausgerichtet sind.

**7.** Patchkabel nach einem der vorhergehenden Ansprüche, wobei jeder der ersten bis vierten Steckkontakte (141 - 144) ein entsprechendes zweites Segment aufweist, das sich von einem Ende der jeweiligen ersten Segmente entlang einer Vorderkante der Leiterplatte (150) nach unten erstreckt.

**8.** Patchkabel nach einem der vorhergehenden Ansprüche, wobei die Leiterplatte (150) eine Vielzahl von leitfähigen Durchkontaktierungen (131-134) umfasst, wobei jeder der ersten bis vierten Steckkontakte (141 - 144) einen Vorsprung aufweist, der in einer jeweiligen der leitfähigen Durchkontaktierungen aufgenommen ist, und wobei die leitfähigen Durchkontaktierungen (131, 133), die die Vorsprünge der ersten und dritten Steckkontakte (141, 143) aufnehmen, in einer ersten Reihe ausgerichtet sind, und die leitfähigen Durchkontaktierungen (132, 134), die die Vorsprünge der zweiten und vierten Steckkontakte (142, 144) aufnehmen, gegenüber der ersten Reihe versetzt sind.

**9.** Patchkabel nach Anspruch 8, das ferner Folgendes umfasst:

    eine fünfte Durchkontaktierung (135), die Teil des ersten leitfähigen Pfads ist, der sich in einem Abschnitt der Leiterplatte (150) befindet, der unterhalb des ersten bis vierten Steckkontakts (141 - 144) liegt, wobei der fünfte Durchgang (135) Teil einer störenden Übersprechschaltung ist; und
    eine sechste Durchkontaktierung (136), die Teil des dritten leitfähigen Pfads ist, der sich in dem Abschnitt der Leiterplatte (150) befindet, der unterhalb des ersten bis vierten Steckkontakts (141 - 144) liegt;
    wobei die störende Übersprechschaltung eine erste störende Übersprechschaltung ist, die ein induktives Übersprechen zwischen dem ersten leitfähigen Pfad und dem vierten leitfähigen Pfad einspeist, wobei der Stecker (116) ferner eine zweite störende Übersprechschaltung umfasst, die die sechste Durchkontaktierung (136) umfasst, die ein induktives Übersprechen zwischen dem zweiten leitfähigen Pfad und dem dritten leitfähigen Pfad injiziert.

**10.** Patchkabel nach einem der vorhergehenden Ansprüche, wobei der Stecker (116) einen RJ-45-Stecker umfasst, der ferner Folgendes umfasst: fünfte und sechste Steckkontakte (145, 146), die Teil einer dritten differentiellen Übertragungsleitung durch den Stecker sind und siebte und achte Steckkontakte (147, 148), die Teil einer vierten differentiellen Übertragungsleitung durch den Stecker sind, wobei der erste, der dritte, der fünfte und der siebte Steckkontakt (141, 143, 145, 147) in entsprechenden ersten bis vierten leitfähigen Durchkontaktierungen (131 - 134) angebracht sind, die im Wesentlichen in einer ersten Reihe ausgerichtet sind, und der zweite, der vierte, der sechste und der achte Steckkontakt (142, 144, 146, 148) in jeweiligen fünften bis achten leitfähigen Durchkontaktierungen (135 - 138) angebracht sind, die im Wesentlichen in einer zweiten Reihe ausgerichtet sind, die von der ersten Reihe versetzt ist.

**11.** Patchkabel nach einem der vorhergehenden Ansprüche, wobei der Signalstrom führende Pfad durch jeden der ersten bis vierten Steckkontakte (141 - 144) in einer longitudinalen Abmessung des Steckers (116) von dem signalstromführenden Pfad von mindestens einem den ersten bis vierten Steckkontakten benachbarten Stecker aus versetzt angeordnet ist.

**12.** Patchkabel nach einem der vorhergehenden Ansprüche, das ferner einen störenden Übersprechkondensator (181) umfasst, der störendes Übersprechen zwischen dem zweiten leitfähigen Pfad und dem dritten leitfähigen Pfad injiziert.

**13.** Patchkabel nach Anspruch 12, wobei der störende Übersprechkondensator (181) einen Leiterplattenkondensator umfasst, der störendes Übersprechen auf den zweiten leitfähigen Pfad im Wesentlichen an einer ersten Schnittstelle zwischen dem zweiten Steckkontakt (142) und der gedruckten Leiterplatte (150) injiziert, und wobei der störende Übersprechkondensator (181) störendes Übersprechen auf den dritten leitfähigen Pfad im Wesentlichen an einer zweiten Schnittstelle zwischen dem dritten Steckkontakt (143) und der gedruckten Leiterplatte (150) injiziert.

**14.** Patchkabel nach Anspruch 12 oder Anspruch 13, wobei der störende Übersprechkondensator (181) dafür konfiguriert ist, störendes Übersprechen auf den zweiten leitfähigen Pfad zu einem Zeitpunkt zu injizieren, der hinter dem Zeitpunkt liegt, zu dem ein Signal, das durch den zweiten Steckkontakt (142) zu einem Kontakt einer passenden Buchse übertragen wird, den Kontakt der passenden Buchse erreicht.

**Revendications**

1. Cordon de connexion (100) comprenant :

un câble de communications (109) qui comporte au moins un premier conducteur (101), un deuxième conducteur (102), un troisième conducteur (103) et un quatrième conducteur (104) ; et
une fiche (116) qui est attachée au câble de communications (109), la fiche comprenant :

un boîtier (120) qui reçoit le câble de communications (109) ;
une carte à circuit imprimé (150) située au moins partiellement à l'intérieur du boîtier (120) ;
un premier contact de fiche (141), un deuxième contact de fiche (142), un troisième contact de fiche (143) et un quatrième contact de fiche (144) qui sont situés chacun au moins partiellement à l'intérieur du boîtier (120) ;
un premier trajet conducteur qui connecte le premier conducteur (101) au premier contact de fiche (141), un deuxième trajet conducteur qui connecte le deuxième conducteur (102) au deuxième contact de fiche (142), un troisième trajet conducteur qui connecte le troisième conducteur (103) au troisième contact de fiche (143), et un quatrième trajet conducteur qui connecte le quatrième conducteur (104) au quatrième contact de fiche (144),
dans lequel les premier et deuxième conducteurs (101, 102), les premier et deuxième trajets conducteurs, et les premier et deuxième contacts de fiche (141, 142) forment une première ligne de transmission différentielle à travers la fiche (116) et les troisième et quatrième conducteurs (103, 104), les troisième et quatrième trajets conducteurs, et les troisième et quatrième contacts de fiche (143, 144) forment une deuxième ligne de transmission différentielle à travers la fiche (116),
dans lequel chacun des premier au quatrième contacts de fiche (141 - 144) comporte un premier segment qui s'étend longitudinalement le long d'une première surface de la carte à circuit imprimé (150) ; et
dans lequel des points d'injection de courant de signal respectifs depuis la carte à circuit imprimé (150) jusque dans les premier et troisième contacts de fiche (141, 143) sont alignés dans une première rangée transversale, et les points d'injection de courant de signal respectifs depuis la carte à circuit imprimé (150) jusque dans les deuxième et quatrième contacts de fiche (142, 144) sont décalés par rapport à la première rangée transversale ;
**caractérisé en ce que** les points d'injection de courant de signal depuis la carte à circuit imprimé (150) jusque dans le premier segment d'au moins certains des premier au quatrième contacts de fiche (141 - 144) se trouvent dans des parties centrales de leur premier segment respectif

2. Cordon de connexion selon la revendication 1, dans lequel le point de connexion fiche-prise sur le premier contact de fiche (141) se trouve sur un premier côté du premier contact de fiche et dans lequel le point d'injection de courant de signal dans le premier contact de fiche se trouve sur un second côté du premier contact de fiche qui est opposé au premier côté et est aussi sensiblement opposé au point de connexion fiche-prise sur le premier contact de fiche.

3. Cordon de connexion selon la revendication 1 ou la revendication 2, dans lequel sensiblement la totalité du premier segment du premier contact de fiche repose directement sur la première surface de la carte à circuit imprimé (150).

4. Cordon de connexion selon l'une quelconque des revendications 1 à 3, dans lequel un chemin de transport de courant de signal minimum à travers le premier contact de fiche (141) est moins du double d'une hauteur du premier contact de fiche au-dessus de la première surface de la carte à circuit imprimé (150).

5. Cordon de connexion selon l'une quelconque des revendications précédentes, dans lequel les premier au quatrième contacts de fiche (141 - 144) s'étendent par pas plus de 30 millièmes de pouce (0,762 mm) au-dessus de la première surface de la carte à circuit imprimé (150).

6. Cordon de connexion selon l'une quelconque des revendications précédentes, dans lequel les points d'injection de courant de signal respectifs dans les deuxième et quatrième contacts de fiche (142, 144) sont alignés dans une seconde rangée transversale.

7. Cordon de connexion selon l'une quelconque des revendications précédentes, dans lequel chacun des premier au quatrième contacts de fiche (141 - 144) présente un second segment respectif qui s'étend vers le bas depuis une extrémité des premiers segments respectifs le long d'un bord avant de la carte à circuit imprimé (150).

8. Cordon de connexion selon l'une quelconque des revendications précédentes, dans lequel la carte à circuit imprimé (150) comporte une pluralité de vias conductrices (131 - 134), dans lequel chacun des premier au quatrième contacts de fiche (141 - 144) présente une protubérance qui est reçue à l'intérieur d'une via respective des vias conductrices, et dans lequel les vias conductrices (131, 133) qui reçoivent les protubérances des premier et troisième contacts de fiche (141, 143) sont alignées dans une première rangée, et les vias conductrices (132, 134) qui reçoivent les protubérances des deuxième et quatrième contacts de fiche (142, 144) sont décalées par rapport à la première rangée.

9. Cordon de connexion selon la revendication 8, comprenant en outre :

   une cinquième via (135) qui fait partie du premier trajet conducteur qui est situé dans une partie de la carte à circuit imprimé (150) qui se trouve en dessous des premier au quatrième contacts de fiche (141 - 144), dans lequel la cinquième via (135) fait partie d'un circuit de diaphonie parasite ; et
   une sixième via (136) qui fait partie du troisième trajet conducteur qui est situé dans la partie de la carte à circuit imprimé (150) qui se trouve en dessous des premier au quatrième contacts de fiche (141 - 144) ;
   dans lequel le circuit de diaphonie parasite est un premier circuit de diaphonie parasite qui injecte une diaphonie inductive entre le premier trajet conducteur et le quatrième trajet conducteur, la fiche (116) comprenant en outre un second circuit de diaphonie parasite qui comporte la sixième via (136) qui injecte une diaphonie inductive entre le deuxième trajet conducteur et le troisième trajet conducteur.

10. Cordon de connexion selon l'une quelconque des revendications précédentes, dans lequel la fiche (116) comprend une fiche RJ-45 qui comporte en outre des cinquième et sixième contacts de fiche (145, 146) qui font partie d'une troisième ligne de transmission différentielle à travers la fiche et des septième et huitième contacts de fiche (147, 148) qui font partie d'une quatrième ligne de transmission différentielle à travers la fiche, dans lequel les premier, troisième, cinquième et septième contacts de fiche (141, 143, 145, 147) sont montés dans des première à quatrième vias conductrices respectives (131 - 134) qui sont sensiblement alignées dans une première rangée et les deuxième, quatrième, sixième et huitième contacts de fiche (142, 144, 146, 148) sont montés dans des cinquième à huitième vias conductrices respectives (135 - 138) qui sont sensiblement alignées dans une seconde rangée qui est décalée par rapport à la première rangée.

11. Cordon de connexion selon l'une quelconque des revendications précédentes, dans lequel le chemin porteur de courant de signal à travers chacun des premier au quatrième contacts de fiche (141 - 144) est décalé dans une dimension longitudinale de la fiche (116) par rapport au chemin porteur de courant de signal d'au moins un contact adjacent des premier au quatrième contacts de fiche.

12. Cordon de connexion selon l'une quelconque des revendications précédentes, comprenant en outre un condensateur de diaphonie parasite (181) qui injecte une diaphonie parasite entre le deuxième trajet conducteur et le troisième trajet conducteur.

13. Cordon de connexion selon la revendication 12, dans lequel le condensateur de diaphonie parasite (181) comprend un condensateur de carte à circuit imprimé qui injecte une diaphonie parasite sur le deuxième trajet conducteur sensiblement au niveau d'une première interface entre le deuxième contact de fiche (142) et la carte à circuit imprimé (150), et dans lequel le condensateur de diaphonie parasite (181) injecte une diaphonie parasite sur le troisième trajet conducteur sensiblement au niveau d'une seconde interface entre le troisième contact de fiche (143) et la carte à circuit imprimé (150).

14. Cordon de connexion selon la revendication 12 ou la revendication 13, dans lequel le condensateur de diaphonie parasite (181) est configuré pour injecter une diaphonie parasite sur le deuxième trajet conducteur à un point dans le temps ultérieur au point dans le temps auquel un signal transmis à travers le deuxième contact de fiche (142) à un contact d'une prise homologue atteint le contact de la prise homologue.

FIG. 1
(PRIOR ART)

PAIR 3

PAIR 2    PAIR 1    PAIR 4

1  2  3  4  5  6  7  8

FIG. 2
(PRIOR ART)

FIG. 3

FIG. 4

FIG. 5

FIG. 6

FIG. 7

FIG. 8

FIG. 9

EP 2 765 656 B1

FIG. 10

24

FIG. 11

FIG. 12

FIG. 13

EP 2 765 656 B1

FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2012100744 A
- US 2010317230 A
- US 5997358 A, Adriaenssens
- US 8197286 B